# EUROPEAN PATENT APPLICATION

(11) **EP 1 930 719 A1**
(43) Date of publication of application: **11.06.2008**
(21) Application number: 06796942.8
(22) Date of filing: 29.08.2006
(51) Int. Cl.: G01N 21/84, F21S 2/00, H01L 51/50, H05B 33/26, F21Y 105/00

(54) **COAXIAL LIGHT RADIATING DEVICE**

(30) Priority: 31.08.2005 JP 2005252728
(71) Applicant: CCS Inc., Kyoto-City, Kyoto 602-8011 (JP)
(72) Inventor: YONEDA, Kenji, Kyoto-city Kyoto 602-8011 (JP)
(74) Representative: Müller - Hoffmann & Partner
(86) International application number: PCT/JP2006/316962
(87) International publication number: WO 2007/026690

(57) **Abstract**

The light irradiation device is for inspecting a surface of an object W such as a product by irradiating the light on the object W, and has an arrangement wherein multiple microscopic EL elements 2, each of which comprises a transparent electrode layer 22 arranged at an object side, a non-transparent electrode layer 23 arranged at an opposite side to the object W and a luminous layer 21 that is arranged between the transparent electrode layer 22 and the non-transparent electrode layer 23 and that emits the light by imparting voltage, are laid out with a space S provided between each other, thereby further promoting more even illumination, downsizing and weight saving.

## Description

### FIELD OF THE ART

This invention relates to a coaxial light irradiation device that can irradiate the light on an object from a direction coaxial to a direction of taking an image of the object.

### BACKGROUND ART

Conventionally, in case of irradiating the light on an object such as a product from a direction coaxial to a direction of taking an image of the object, a coaxial light irradiation device is used that comprises a half mirror inserted at an angle of 45 degree on an observation axis wherein the light is irradiated on the half mirror from a direction orthogonal to the observation axis.

Furthermore, recently a coaxial light irradiation device that does not require a half mirror and is significantly downsized and can take an image in a closeup mode has been developed as shown in the patent document 1.

More concretely, the light irradiation device is so arranged that multiple microscopic reflecting members are laid out on a surface at an object side of a thin light permeable plate so as to form a space therebetween and LED light is introduced through a side surrounding surface of the light permeable plate. The light irradiation device is of a thin plate as a whole and can be inserted in a direction orthogonal to an observation axis. The light travels inside the light permeable plate while being reflected totally, a part of which is reflected on the reflecting members and is irradiated toward the object from a surface at an object side of the light permeable plate so as to illuminate the object. Since the image-taking device is so arranged to have a space between the reflecting members, it is possible to take an image of the object without being affected by the reflecting members like we can see a bright room through a screen.
Patent document 1: Japan patent laid open number 2003-98093

### DISCLOSURE OF THE INVENTION

### PROBLEMS TO BE SOLVED BY THE INVENTION

However, with this light irradiation device, if the reflecting members are laid out in even density, the light reflected on a reflecting members arranged in a surrounding section of the light permeable plate becomes strong, meanwhile the light reflected on a center part becomes week because the light enters from a surrounding area of the light permeable plate, thereby generating uneven intensity of illumination. In order to avoid this, it is necessary to arrange the reflecting members so as to be the closer to a center part, the higher in density. However, it is preferable to arrange the reflecting members evenly as much as possible from a standpoint of taking images, and it might be a burden on manufacturing the light irradiation device to change a distribution density of reflecting members.

In addition, since it is necessary to arrange the LEDs at a surrounding area of the light permeable plate, the light irradiation device is likely to be bulky in a radial direction. Then in consideration of applying this light irradiation device to a microscopical image-taking field, it is necessary to promote further downsizing and weight saving.

Then the present claimed invention intends to provide a light irradiation device that can be used for coaxial illumination and that can emit the light more evenly and further promote downsizing and weight saving.

### MEANS TO SOLVE THE PROBLEMS

More specifically, the light irradiation device, for inspecting a surface of an object such as a product by irradiating the light on the object, is characterized by that multiple microscopic EL elements, each of which comprises a transparent (light permeable) electrode layer arranged at an object side, a non-transparent electrode layer arranged at an opposite side to the object and a luminous layer that is arranged between the transparent electrode layer and the non-transparent electrode layer and that emits the light by imparting voltage, are arranged with a space provided between each other. EL is an abbreviation for Electro Luminescence. The luminous layer may have a laminar structure comprising PN semiconductors, or may be comprised of organic macromolecule or low molecular such as an organic EL element to be described later.

As an EL element that can be miniaturized and can contribute to moire restraint, an organic EL element can be represented.

In order to make it possible to take an image of the object preferably by effectively irradiating the light from the luminous layer on an object and restraining the light reflection on a surface at an opposite side to the object of the EL elements (a surface at a side of the image-taking device), it is preferable that a surface at a side of a luminous layer of the non-transparent electrode layer is a light reflecting surface, and a surface at its opposite side of the non-transparent electrode layer is a light shielding surface that shields or absorbs the light.

In order to make it possible to supply the electric power to each EL element without difficulty, it is preferable that the electrode layer as a whole of the EL elements is so arranged to form a lattice shape by connecting the electrode layers of the adjacent EL elements.

As a concrete form to support the EL elements, it can be represented that a light permeable plate having a predetermined thickness is further comprised and the EL elements are pasted to either one surface of the light permeable plate.

### EFFECT OF THE INVENTION

With the light irradiation device having the above arrangement in accordance with the present claimed invention, since each EL element emits the light voluntarily, it is possible to emit the light evenly with an even layout density and to provide illumination preferable for image-taking.

Furthermore, since the light irradiation device does not require an additional light source such as LEDs to be arranged around the light irradiation device, it is possible to further promote downsizing and weight saving.

### BRIEF DESCRIPTION OF THE DRAWINGS

Fig. 1 is a center longitudinal front end view showing an internal structure of a light irradiation device in accordance with one embodiment of the present claimed invention.
Fig. 2 is a plane view of the light irradiation device in accordance with this embodiment.
Fig. 3 is a detail view of the A section in Fig. 2.
Fig. 4 is an end view of a part of B-B line in Fig. 3.

### EXPLANATION OF THE CODES

1 ... light irradiation device
3 ... transparent (light permeable) plate
3a ... one surface (object facing surface)
3b ... other surface (opposite object facing surface)
2 ... organic EL element
6 ... image-taking device (CCD camera)
S ... space
W ... object

### BEST MODES OF EMBODYING THE INVENTION

One embodiment of the present claimed invention will be explained with reference to drawings.

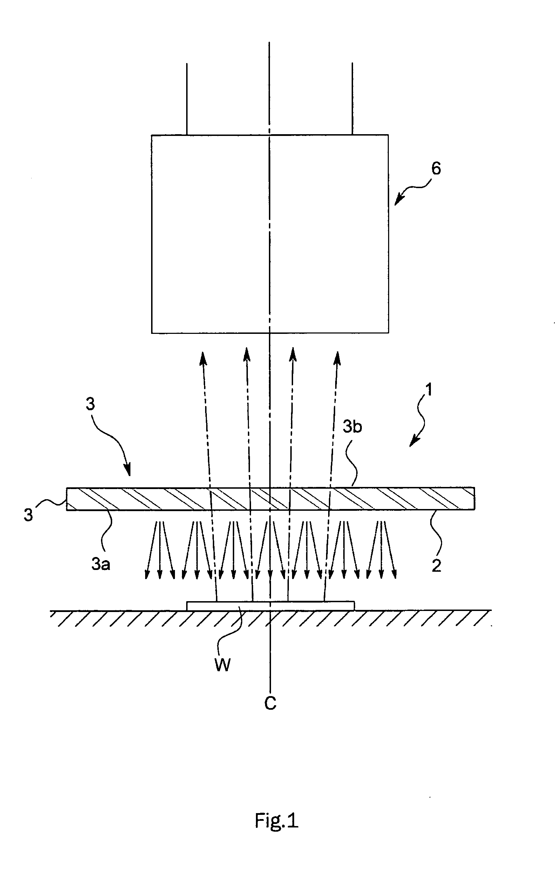

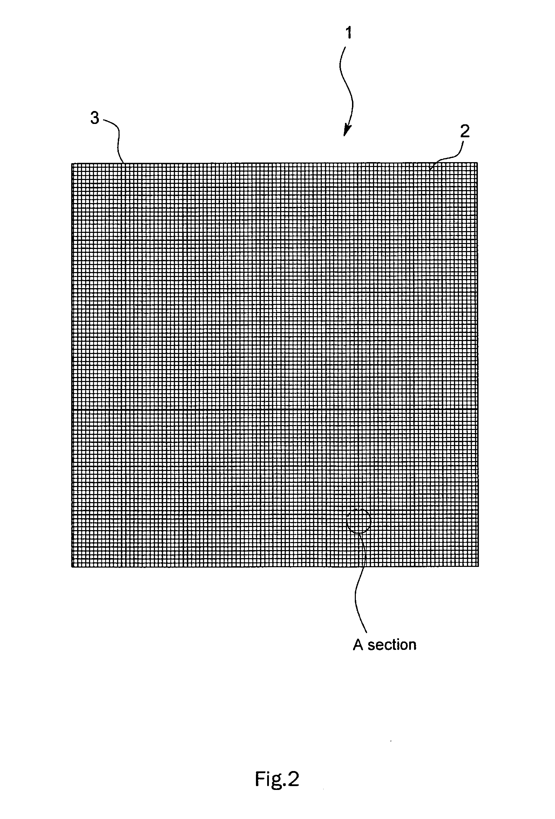

A light irradiation device 1 in accordance with this embodiment is, whose schematic view is shown in Fig. 1 and Fig. 2, in a thin plate shape as a whole, and arranged on an image-taking axis C between an object W such as a product as being an object on which the light is to be irradiated and an image-taking device 6 such as a CCD camera orthogonally to the image-taking axis C. The light irradiation device 1 illuminates the object W and makes it possible for the image-taking device 6 to take an image of the object W by transmitting a part of the light from the object W.

Concretely, the light irradiation device 1 comprises a platy rectangular transparent (light permeable) plate 3, multiple (plurality of) organic EL elements 2 pasted on one surface of the transparent plate 3 and a light source section, not shown in drawings, that supplies electric currents to the organic EL elements 2.

The transparent plate 3 is a transparent and colorless plate form having an equal thickness and of a square shape in a plane view, whose one surface as being an object facing surface 3a is placed to face the object W, and is made of a material, for example, acrylic or glass.

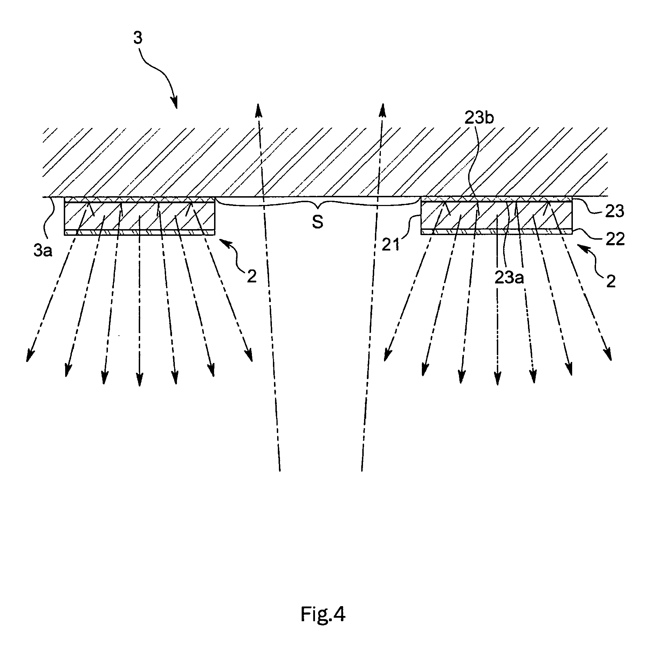

The organic EL elements 2, whose end view is schematically shown in Fig. 4, is a sandwich structure where the luminescence layer 21 is placed between two electrode layers 22, 23, and voluntarily emits the light at a time when the voltage is applied between the electrode layers 22, 23 so as to supply the electric current to the luminescence layer 21.

The electrode layer 22 (anode) at an object side is made of a transparent material such as, for example, ITO, and the electrode layer 23 (cathode) at an opposite side to the object W is made of a non-transparent metal plate. A surface (a surface 23a at a side of the luminescence layer) at the object side the non-transparent electrode layer 23 (cathode) is mirror finished to reflect the light, and a surface 23b at the opposite side to the object W is plated with mat black finished to shield or absorb the light.

The luminescence layer 21 is made of, for example, poly phenylene vinylenen (PPV) and may be of low molecular. In addition, as shown in Fig. 4, the electrode layers 22, 23 are directly pasted to both front and back surfaces of the luminescence layer 21, however, the electrode layers 22, 23 may be pasted through an electron hole transporting bed and an electron transporting bed.

A thickness of the organic EL element 2 as a whole is extremely thin such as several hundred nm and below, and a size (a size in a direction orthogonal to a direction of the thickness) of each organic EL element 2 is also extremely small such as several dozen µm and below.

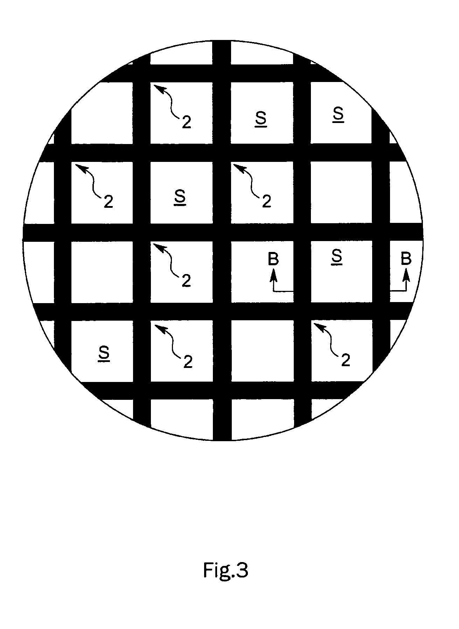

Then in this embodiment, multiple organic EL elements 2 are so arranged to have a space S therebetween in a plane view as shown in Fig. 2 and Fig. 3.

More specifically, as shown in Fig. 3, the electrode layers 22, 23 as a whole of the EL electrodes 2 are so arranged to form a lattice shape by connecting the electrode layers 22, 23 of adjacent EL electrodes 2.

Next, an operation of the light irradiation device 1 of the above arrangement will be explained as follows.

First, as shown in Fig. 1, the object W is set to face the image-taking device 6. During this process, the light irradiation device 1 is placed on the image-taking axis C so that the object facing surface 31a faces the object W.

With this state kept, when the electric power is supplied, the light is irradiated from each of the organic EL elements 2 toward the object W. More specifically, the light occurred on the luminescence layer 21 directly travels toward the transparent electrode layer 22 or is reflected on the non-transparent electrode layer 23 and then travels toward the transparent electrode layer 22 and passes the transparent electrode layer 22 and then is irradiated on the object W. The object W is illuminated uniformly.

The image-taking device 6 takes an image of the object W by acquiring the light that is reflected on the object W and passes the transparent plate 3 through the space S between the organic EL elements 2 so that a surface of the object W is inspected or a mark on the object W is read. Since the organic EL elements 2 are microscopic, the organic EL elements will not fundamentally be an obstacle to taking an image like we can see a bright room through a screen. Especially in this embodiment, since the surface 23b at the opposite side to the object W of the organic EL element 2 is a light shielding surface that restrains reflection or scattering of the light, the light reflected on the organic EL elements 2 is not captured by the image-taking device 6, thereby enabling a preferable image-taking.

It is more preferable that a size or a pitch of the space S or the organic EL elements 2 is optimally determined with a distance between the image-taking device 6 and the organic EL elements 2 or a distance between the image-taking device 6 and the object W set as a parameter. For example, in case that the distance between the image-taking device 6 and the organic EL elements 2 is short, a size or a pitch of the space S or the organic EL elements 2 may be set big properly, and vice versa.

As mentioned, it is possible to illuminate the object W from a coaxial direction of the monitoring axis C of the image-taking device 6 by the light irradiated from the organic EL elements 2 and to conduct inspection by taking an image of the object W through the space S by the image-taking device 6.

As a result, with the coaxial light irradiation device 1 of the above arrangement in accordance with this embodiment, since each EL element 2 arranged in even density voluntarily emits the light respectively, it is possible to evenly illuminate the object W without any uneven illumination intensity.

Furthermore, since the light irradiation device 1 has a simple structure wherein extremely thin organic EL elements 2 are pasted to one surface 3a of the transparent plate 3 and a whole size of the light irradiation device 1 can be made substantially the same as that of the transparent plate 3, it is possible to further promote downsizing and weight saving.

In addition, since the organic EL element 2 can be enlarged comparatively easily, it is also possible to manufacture a light irradiation device having a big luminescent area. Furthermore, since each of the organic EL elements 2 can be extremely miniaturized, it is possible to restrain the interference stripes (moire) that might occur in relation with the CCD picture element.

The present claimed invention is not limited to the above-mentioned embodiment.

For example, a shape of each EL element is not limited to a quadrangular lattice shape, and may be a triangular lattice shape or may be a discontinuous dot matrix.

In addition, the EL element may be pasted to a surface of opposite side to the object of a transparent plate, or may be arranged by embedding the EL elements in a thickness of the transparent plate.

The EL element is not limited to monochromatic, and may be various colors comprising three primary colors to illuminate the object.

Furthermore, the transparent plate is not limited to a flat plate, and may be a curved plate such as a spherical shape.

In addition, the present claimed invention is not limited to the above-mentioned illustrated embodiment and the above-mentioned explanatory embodiment, and it is a matter of course that each component may be appropriately combined and variously modified without departing from the spirit of the invention.

### POSSIBLE APPLICATIONS IN INDUSTRY

With the light irradiation device of the above arrangement in accordance with the present claimed invention, since each EL element emits the light voluntarily, it is possible to emit the light evenly with even layout density and to provide illumination preferable for image-taking. In addition, since the light irradiation device does not require an additional light source such as LEDs to be arranged around the light irradiation device, it is possible to further promote downsizing and weight saving.

## Claims

1. A light irradiation device, for inspecting a surface of an object such as a product by irradiating the light on the object, wherein multiple microscopic EL elements, each of which comprises a transparent electrode layer arranged at an object side, a non-transparent electrode layer arranged at an opposite side to the object and a luminous layer that is arranged between the transparent electrode layer and the non-transparent electrode layer and that emits the light by imparting voltage, are laid out with a space provided between each other.

2. The light irradiation device described in claim 1, wherein the EL element is an organic EL element.

3. The light irradiation device described in claim 1, wherein a surface at a side of a luminous layer of the non-transparent electrode layer is a light reflecting surface, and a surface at its opposite side of the non-transparent electrode layer is a light shielding surface that shields or absorbs the light.

4. The light irradiation device described in claim 1, wherein the electrode layer as a whole of the EL elements is so arranged to form a lattice shape by connecting the electrode layers of adjacent EL elements.

5. The light irradiation device described in claim 1, 2, 3 or 4, wherein a light permeable plate having a predetermined thickness is further comprised and the EL elements are pasted to either one surface of the light permeable plate.
